# EUROPÄISCHE PATENTSCHRIFT

(11) **EP 0 300 995 B1**
(45) Veröffentlichungstag und Bekanntmachung des Hinweises auf die Patenterteilung: **08.02.1995**
(21) Anmeldenummer: 88890192.3
(22) Anmeldetag: 20.07.1988
(51) Int. Cl.: H01J 37/34, C23C 14/34

(54) **Stabförmige Magnetron- bzw. Sputterkathodenanordnung, Sputterverfahren, Vorrichtung zur Durchführung des Verfahrens und rohrförmiges Target**
Rod shaped magnetron or sputter cathode arrangement, sputtering process, device for implementing the process and tube shaped target
Dispositif en forme de barre d'un magnétron ou d'une cathode de pulvérisation, procédé de pulvérisation, dispositif pour la mise en oeuvre dudit procédé et cible en forme de tube

(30) Priorität: 24.07.1987 AT 1881/87; 01.09.1987 AT 2193/87
(43) Veröffentlichungstag der Anmeldung: 25.01.1989
(73) Patentinhaber: MIBA Gleitlager Aktiengesellschaft, A-4663 Laakirchen (AT)
(72) Erfinder: Gärtner, Walter, Dipl. Ing., A-481o Gmunden (AT); Koroschetz, Franz, Dipl. Ing. Dr., A-481o Gmunden (AT); Wagendristel, Alfred, Dipl. Ing. Dr., A-238o Perchtoldsdorf (AT); Bangert, Herwig, Dipl. Ing. Dr., A-1235 Wien (AT)
(74) Vertreter: Hübscher, Helmut, Dipl.-Ing.

(56) Entgegenhaltungen:
- EP-A- 0 081 176
- EP-A- 0 134 559
- DE-A- 3 030 329
- PATENT ABSTRACTS OF JAPAN vol. 9, no. 66 (C-271)(1789) 26 März 1985, & JP-A-59 197570
- PATENT ABSTRACTS OF JAPAN vol. 8, no. 236 (C-249)(1673) 30 Oktober 1984, & JP-A-59 116375
- THIN SOLID FILMS. vol. 64, no. 3, 1979, LAUSANNE CH Seiten 455-467; S. Schiller et al.: "Advances in high rate sputtering with magnetron-plasmatron processing and instrumentation"
- THIN SOLID FILMS. vol. 96, 1982, LAUSANNE CH Seiten 217 - 224; D W Hoffman: "Design and capabilities of a novel cylindrical-post magnetron sputtering source"

## Beschreibung

Die Erfindung bezieht sich auf eine stabförmige Magnetron- bzw. Sputterkathodenanordnung mit einem innenliegenden, gekühlten Permanentmagnetsystem und einem Trägerrohr für das auf das stabförmige, vorzugsweise aus nichtmagnetischem Stahl, bestehende Trägerrohr aufgebrachte, gegebenenfalls aus unterschiedlichen Targetmaterialien zusammengesetzte Target. Derartige Anordnungen dienen insbesondere zum Besputtern von zumindest teilweise gekrümmten Flächen bzw. von Innenflächen von hohlen oder aus Teilen zu solchen zusammengesetzten Körpern, z. B. von Zylinderinnenflächen, polygonen oder rosettenförmigen Innenflächen od. dgl. Ferner betrifft die Erfindung ein Sputterverfahren zum Sputtern mit einer Magnetron- bzw. Sputterkathodenanordnung, vorzugsweise zum Besputtern von gekrümmte Bereiche aufweisenden Flächen, z. B. den Innenflächen von Hohlkörpern, sowie eine Vorrichtung zur Durchführung dieses Verfahrens und ein rohrförmiges Target.

Aus der US-A-4 521 286 ist eine Ätz- bzw. Beschichtungseinrichtung mit einer Hohlkathode mit parallelen Elektrodenflächen bekannt; eine stabförmige Magnetron- bzw. Sputterkathodenanordnung ist nicht vorhanden.

Aus der EP-A1-0 070 889 ist eine Magnetron- bzw. Sputterkathodenanordnung der eingangs genannten Art bekannt, die zum Besputtern ebener Flächen eingesetzt wird. Bei dieser Anordnung ist ferner vorgesehen, daß die zu besputternde Fläche senkrecht zur Achse der ortsfesten Kathodenanordnung bewegt wird, die ein Trägerrohr umfaßt, auf das unterschiedliche Targetmaterialien aufgebracht sind, und daß das Trägerrohr um dessen Längsachse kontinuierlich rotierbar ist, so daß z. B. verschiedene Materialien, die in verschiedenen Sektoren angeordnet sind, nacheinander vor dem nur in einem bestimmten Sektor innen angeordneten, U-förmigen und gekühlten Permanentmagnetsystem in Position gebracht werden können.

Um das Beschichtungsmaterial bei einer rotierbaren Magnetronkathodenanordnung einfach austauschen zu können, ist es außerdem bekannt (EP-A2-0 134 559), die Targetmaterialien in axialen Streifen über den Umfang eines Trägerrohres verteilt an diesem festzuklemmen, so daß die jeweils ausgewählten Targetstreifen durch eine Drehung des Trägerrohres gegenüber dem ortsfesten Permanentmagnetsystem ausgerichtet werden können.

Zum schnelleren Targetwechsel ist es nach der EP-A1-0 081176 bekannt, das plattenförmige Target auf seiner Halterung nicht aufzulöten, sondern aufzuschrauben, wobei vorgeschlagen wird, zwischen dem Target und der Halterung eine wärmeleitende Schicht vorzusehen, damit der durch die Schraubverbindung gegenüber einer Lötverbindung schlechtere Wärmeübergang zwischen Target und Halterung ausgeglichen wird. Um auch ohne zusätzliche Zwischenschicht einen guten Wärmeübergang zu ermöglichen, ist es schließlich bekannt (DE-A1-3 030 329), den plattenförmigen Targetkörper mit seiner Halterung durch ein Aufschrumpfen zu verbinden.

Ziel der Erfindung ist es, Materialien, die aus Festigkeitsgründen für eine Fertigung selbsttragender Targets ungeeignet sind, und beliebige Materialkombinationen, die durch andere Verfahren (z. B. galvanisch, schmelz- oder pulvermetallurgisch) nicht oder nur schwierig herstellbar sind, einem Hochleistungssputterprozeß zugänglich zu machen, und die strukturelle Ausbildung der aufgesputterten Beschichtung, z. B. auf der Innenfläche von Lagerschalen, zu verbessern. Ferner sollen die aufgrund der unterschiedlichen Wärmeausdehnungen von Targetmaterial und Trägerrohr auftretenden Probleme gelöst werden, die sich vor allem bei der Verwendung stabförmiger Kathoden mit kleinerem Durchmesser ergeben.

Dieses Ziel wird bei einer stabförmigen Magnetron- bzw. Sputterkathodenanordnung der eingangs geschilderten Art dadurch erreicht, daß zwischen dem aus einem oder mehreren, insbesondere austauschbar auf das Trägerrohr aufgezogenen Ring(en) bestehenden Target und dem Trägerrohr zumindest eine Wärmekontaktschicht angeordnet ist und daß der bzw. die gegebenenfalls im warmen Zustand auf das Trägerrohr aufgebrachte(n) Ring(e) im Betriebszustand mit Preßsitz auf dem Trägerrohr bzw. der Wärmekontaktschicht sitzt bzw. sitzen.

Die zwischen dem Trägerrohr und den Ringen aus Targetmaterial angeordnete Wärmekontaktschicht aus Metall ermöglicht einen optimalen Wärmeübergang von dem durch die Gasentladung erhitzten Targetmaterial zum Trägerrohr, das ja von den Targetringen umschlossen wird, und von dort auf ein zwischen dem Trägerrohr und dem Permanentmagnetsystem fließendes Kühlmittel, zumal durch den Preßsitz der Ringe auf dem Trägerrohr bzw. auf der Wärmekontaktschicht ein über den gesamten Umfang des Trägerrohres gleichmäßig guter Wärmeübergang möglich ist. Damit wird erreicht, daß das Targetmaterial ausreichend gekühlt wird, d. h. bei entsprechend hoher Leistungsdichte nicht aufschmilzt. Es kann deshalb auch ein dickerer Targetring verwendet werden, womit die Standzeiten der Anordnung erhöht werden.

Aufgrund der erfindungsgemäßen Vorgangsweise können beliebige Targetmaterialien, z. B. auch solche mit geringer mechanischer Festigkeit, die zur Fertigung selbsttragender Targets ungeeignet sind, auf das Trägerrohr aufgezogen werden. Die erfindungsgemäße Anordnung ermöglicht es, Schichten auch aus solchen Legierungen mit einer Stabkathode zu produzieren, für die eine schmelz- oder sintertechnologische Herstellung von ringförmigen Targets bisher nicht bzw. nur unter größten Schwierigkeiten möglich war. Unterschiedliche Wärmedehnungen des Targetmaterials und des Trägerrohres werden von der Wärmekontaktschicht aufgenommen.

Bevorzugt ist es, wenn bei im Inneren des Trägerrohres um dessen Längsachse insbesondere kontinuierlich rotierbaren, z.B. von einer rotierbaren Welle getragenen und vom Kühlmedium umströmten Permanentmagneten die Magnete mit in Längsrichtung des Trägerrohres alternierend entgegengesetzter Richtung ihres Magnetfeldes innerhalb des Trägerrohres angeordnet sind. Diese Ausbildung der Kathodenanordnung bzw. des Permanentmagnetsystems ermöglicht eine gleichmäßige Abarbeitung bzw. Abtragung des Targetmaterials beim Sputtern und damit eine bessere Ausnützung des Targetmaterials sowie eine gleichmäßige Aufbringung der Schicht für die zu besputternden Flächen. Vorteilhaft ist es hiebei, wenn die zylindrische oder polygonale Mantelflächenbesitzenden Magnete parallele und im Winkel zur Längsrichtung der Elektrode bzw. Welle geneigt verlaufende Endflächen besitzen, wobei die einander zugewandten Endflächen aufeinanderfolgender Magnete entgegengesetzte Magnetpole aufweisen.

Um eine hohe Leistungsdichte auf der Targetoberfläche während eines Dauerbetriebes zu ermöglichen, ist insbesondere die Kühlung des Targetmaterials von Bedeutung. Dazu ist erfindungsgemäß vorgesehen, daß die Magnete eine rohrförmige Ausnehmung in Längsrichtung des Trägerrohres aufweisen, mit der sie gegebenenfalls auf die Welle aufgeschoben sind, daß die Ausnehmung bzw. die als Hohlwelle ausgebildete Welle als Kühlmitteldurchfluß ausgebildet und an eine Kühlmittelzufuhreinrichtung angeschlossen ist und daß die Magnete in dem Trägerrohr unter Ausbildung eines Spaltes angeordnet sind, wobei der Spalt zwischen dem Trägerrohr und den gegebenenfalls von einem Hüllrohr umgebenen Magneten als Kühlmitteldurchfluß, insbesondere Kühlmittelrückleitung, ausgebildet ist. Der hiedurch gegebene kreisringförmige Strömungsquerschnitt soll für das Kühlmedium bei der vorgegebenen Kühlmittelgeschwindigkeit eine Reynoldzahl >10.000 ergeben. Die Dicke des Ringspaltes zwischen den Magneten bzw. dem Hüllrohr und dem Trägerrohr kann etwa 0,5 mm betragen und es wird ein Kühlwasserdruckkreislauf mit einem Druck von 12 bar ausgebildet. Im Endbereich der Hohlwelle kann eine strömungsgünstig geformte, schalenförmige Umlenkung für das aus der Hohlwelle austretende Kühlmittel vorgesehen sein, um dieses in den Kühlspalt umzulenken.

Um die hohe Sputterleistungsdichte am Target zu erzielen, muß das Plasma in unmittelbarer Nähe der Targetoberfläche magnetisch eingeschlossen werden. Dazu ist eine wirksame magnetische Feldstärke parallel zur Zylinderoberfläche des Targetmaterials von vorzugsweise 0,03 Vsm⁻² (300 Gauß) erforderlich. Die ses Feld wird durch die Magnete erzeugt, die vorzugsweise aus SmCO₅ bestehen. Auf Grund der besonderen Konfiguration der einzelnen rotierenden aufeinander folgenden Magnete wird im zeitlichen Mittel eine gleichmäßige Dichte des Plasmas auf einem die Targetoberfläche umgebenen Zylindermantel erreicht. Daraus resultiert ein gleichmäßiger Abtrag des Targets. So kann z.B. mit der erfingungsgemäßen Stabkathode eine Beschichtungsrate von 1 »m/min Aluminium im Abstand von 30 mm von der Targetoberfläche erreicht werden, welche Leistung bereits über der Grenze von handelsüblichen Hochleistungsflachkathoden liegt und die Leistung bekannter Stabkathoden bei weitem übertrifft.

Vorteilhaft ist es, wenn die zwischen dem(n) Ring(en) und dem Trägerrohr angeordnete, vorzugsweise 5 - 50 »m, insbesondere 10 - 20 »m, dicke Wärmekontaktschicht aus weichem bzw. verformbarem, insbesondere mit einer Härte <20 MHV, niedrig schmelzendem, gut wärmeleitendem Metall bzw. einer solchen Legierung, z.B. In, Ga, Pb, Sn od.dgl., besteht, die vorzugsweise auf das Trägerrohr abgelagert ist. Wenn die Wärmekontaktschicht einen größeren Ausdehnungskoeffizienten besitzt als die auf das Trägerrohr aufgezogenen Ringe, treten keine die Wärmeableitung behindernden Zwischenräume bei Erwärmung der Kathode auf. Gleichzeitig ist jedoch erforderlich, daß das Metall der Wärmekontaktschicht weich ist, um die entstehenden Spannungen unter Verformung aufnehmen zu können. Besonders vorteilhaft ist es, wenn ein Metall für die Wärmekontaktschicht eingesetzt wird, das bei Temperaturen unter dem Erweichungspunkt, insbesondere Schmelzpunkt, des jeweiligen Targetmaterials schmilzt und somit bei lokaler Überhitzung des Targetmaterials wegen lokal schlechten Wärmekontaktes durch Aufschmelzen der Schicht und Nachfließen des Schichtmaterials in die Bereiche den Wärmeschluß wieder herstellt. Da die Ringe mittels eines Preßsitzes auf das Trägerrohr aufgebracht sind, ergibt sich durch die gute Verformbarkeit des Metalls der Schicht ein optimaler Wärmeübergang auch bei nicht geschmolzenem Metall.

Zur Ausbildung von Schichten aus mehreren Einzelkomponenten ist es vorteilhaft, wenn auf das Trägerrohr in axialer Richtung aufeinanderfolgend insbesondere in vorbestimmter Reihenfolge Ringe gegebenenfalls unterschiedlicher Breite aus unterschiedlichem Targetmaterial aufgezogen sind.

Ein rohrförmiges Target, insbesondere für erfindungsgemäße Sputterkathodenanordungen ist erfindungsgemäß dadurch gekennzeichnet, daß zwischen dem Trägerrohr des rohrförmigen Targets und dem Targetmaterial zumindest eine vorzugsweise 5 - 50 »m, insbesondere 10 - 20 »m, dicke Wärmekontaktschicht aus weichem bzw. verformbaren, insbesondere mit einer Härte <20 MHV, niedrig schmelzendem, gut wärmeleitendem Metall oder einer entsprechenden Legierung, z.B. In, Ga, Pb, Sn, Wood'sches Metall od.dgl. vorgesehen ist, wobei auf das Trägerrohr in axialer Richtung zumindest ein, vorzugsweise eine Anzahl aufeinanderfolgender gegebenenfalls aus unterschiedlichen Targetmaterialien bestehender, gegebenenfalls unterschiedliche Breite besitzender, Ring(e) aufgebracht ist, wobei der (die) Ring(e) gegebenenfalls in warmem Zustand auf das Trägerrohr aufgezogen und nach dem Abkühlen im Betriebszustand mit Preßsitz auf dem Trägerrohr bzw. der Wärmekontaktschicht angeordnet ist (sind), wobei gegebenenfalls das Metall der Schicht(en) einen Wärmeausdehnungskoeffizienten besitzt, der größer ist als der des Targetmaterials.

Das erfindungsgemäß Sputterverfahren, vorzugsweise zum Besputtern von gekrümmte Bereiche aufweisenden Fläche, z.B. den Innenflächen von Hohlkörpern, wobei die zu besputternde Fläche und die Kathodenanordnung, die ein Trägerrohr umfaßt, auf das unterschiedliche Targetmaterialien aufgebracht sind, einer gegenseitigen Relativbewegung unterworfen werden, wobei vorzugsweise die Kathodenanordnung lagefest gehalten und die Fläche bzw. der die Fläche tragende Körper bewegt wird, ist dadurch gekennzeichnet, daß die Kathodenanordnung, auf deren Trägerrohr mehrere in axialer Richtung des Trägerrohres aufeinanderfolgende Ringe aus unterschiedlichem Targetmaterial aufgezogen werden, und die zu besputternde Fläche einer gegenseitigen Relativbewegung in Längsrichtung der Kathodenanordnung bzw. des Trägerrohres unterworfen werden. Dabei kann vorgesehen sein, daß die Relativbewegung zwischen der Kathodenanordnung und der zu besputternden Fläche eine Pendelbewegung ist, deren Hub größer als die Breite eines, insbesondere des breitesten vorhandenen, Ringes aus Targetmaterial, gewählt ist oder daß die Relativbewegung eine Verschiebebewegung ist und eine Vorschubbewegung des die zu besputternde Fläche tragenden Körpers in bezug auf die Längsrichtung der Kathodenanordnung umfaßt, der eine Pendelbewegung überlagert ist. Auf diese Weise werden die durch die Targetsegmentierung bzw. die durch aufeinanderfolgend angeordnete Ringe aus unterschiedlichen Targetmaterialien hervorgerufenen lokalen Konzentrationsunterschiede beim Aufbau der Schicht ausgeglichen und eine Schicht der gewünschten Legierung in gleichmäßiger Zusammensetzung erzielt.

Eine Vorrichtung zur Durchführung dieses Verfahrens mit einer Verstelleinrichtung ist dadurch gekennzeichnet, daß die Kathodenanordnung und/oder die zu besputternde Fläche von der von einer in Längsrichtung des Trägerrohres eine Vorschub- und/oder Hin- und Herbewegung (Pendelbewegung) ausführenden Trägereinrichtung gebildeten Verstelleinrichtung, die gegebenenfalls von einer Förder- bzw. Antriebseinrichtung betätigbar ist, getragen bzw. mit dieser verbunden sind. Die Förder- bzw. Antriebseinrichtung für die zu besputternde Fläche und/oder für den die Fläche tragenden Körper kann mit der z.B. außerhalb des Rezipienten, in dem der Sputtervorgang vor sich geht, angeordneten Verstelleinrichtung verbunden sein, die über vakuumdichte Antriebe bzw. Stelleinrichtungen die Verstellung des Körpers und/oder der zu besputternden Fläche während des Sputterns bewirken.

Weitere vorteilhafte Ausführungsformen der Erfindung sind der folgenden Beschreibung, der Zeichnung und den Patentansprüchen zu entnehmen.

Im folgenden wird die Erfindung an Hand der Zeichnung näher erläutert:

Es zeigen: Fig. 1 eine Sputterstation, Fig. 2 eine bevorzugte Ausführungsform einer erfindungsgemäßen Sputterkathodenanordnung, Fig. 3 einen Detailschnitt durch eine Sputterkathodenanordnung und Fig. 4 eine Ansicht eines erfindungsgemäßen Targetrohres.

Besonders gut können die erfindungsgemäße Kathodenanordnung und das erfindungsgemäße Verfahren zum Besputtern von Lagerschalen mit Lagerschichtlegierungen eingesetzt werden. Demgemäß ist die Erfindung anhand der Beschichtung von Lagerschalen durch Kathodenzerstäubung ("Sputtern") als Beispiel näher erläutert. Andere Verwendungszwecke sind z.B. das Besputtern von Kugellagerlaufflächen, Rohrinnenflächen usw.

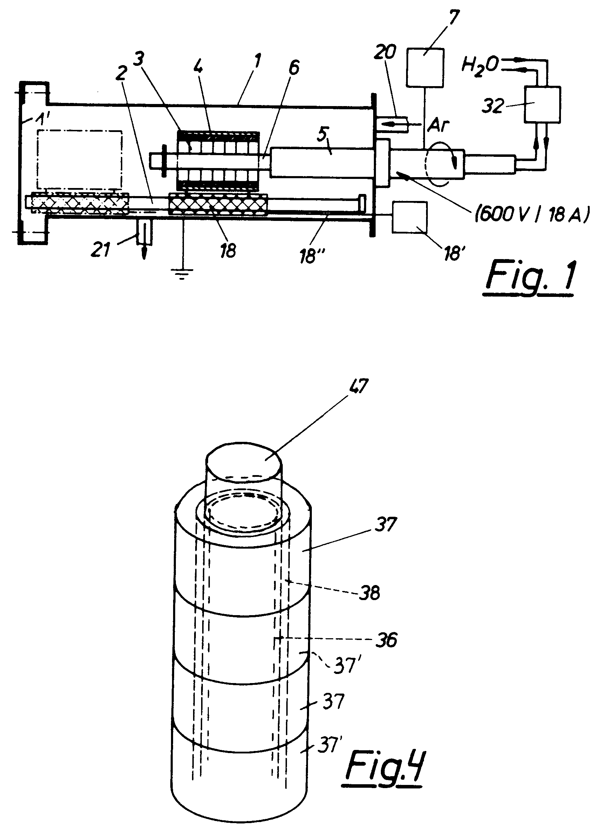

Die vorteilhafterweise in einer Reihe zu einem Zylinder aneinandergefügten Lagerschalen werden in einen Träger 4 eingesetzt, der in eine Beschichtungsanlage einbringbar ist. Eine derartige Sputteranlage ist in Fig. 1 schematisch dargestellt. Die Anordnung umfaßt einen gasdichten Rezipienten 1 mit einem aufschraubbaren Deckelteil 1′. Im Rezipienten 1 sind Fördereinrichtungen, z.B. ein auf Führungen 2 verfahrbarer Träger 18, vorgesehen, auf bzw. mit denen der Träger 4 mit den Lagerschalen 3 zwischen einer Ein- bzw. Austragstellung (strichliert) und einer Sputterstellung verfahrbar ist, in der die Sputterkathode 6 von den Lagerschalen 3 umschlossen wird. Nach Beendigung des Sputtervorganges wird der Träger 4 dem Rezipienten 1 entnommen.

Mit 20 ist eine Gaszufuhrleitung und mit 21 eine Leitung zu einer Vakuumpumpe bezeichnet. Der Spannungsanschluß (z.B. -600 V) der Sputterkathode 6 ist mit 7 bezeichnet; die Kühlwasserzufuhreinrichtung der Kathode 6 mit 32. Das Sputtern erfolgt bei einer Temperatur des Targetmaterials von 30 bis 100°C, vorzugsweise 80°C, und einem Druck von etwa 2 . 10⁻³ mbar.

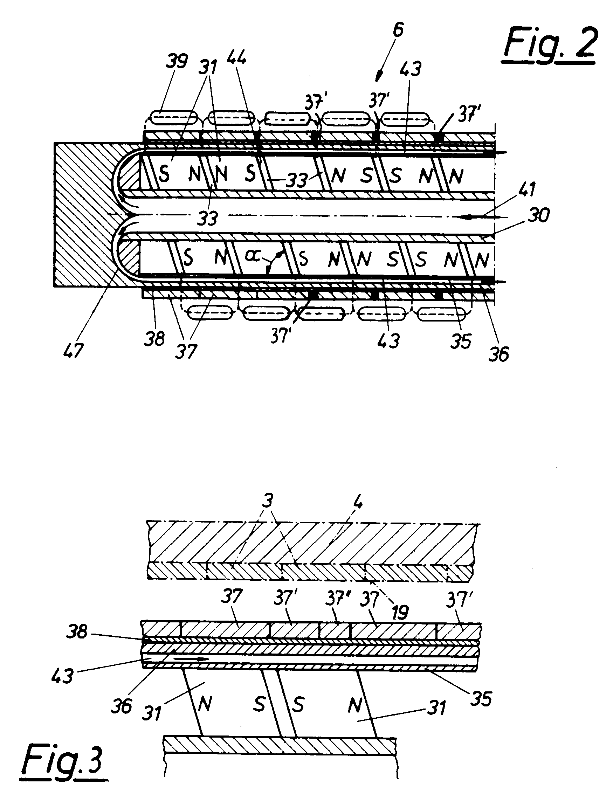

Eine erfindungsgemäße Kathodenanordnung 6, wie sie in Fig. 2 im Schnitt durch ihre Längsachse dargestellt ist, umfaßt auf einer Hohlwelle 30 angeordnete Permanentmagnete 31. Die Magnete sind im vorliegenden Fall zylindrisch ausgebildet, könnten aber im Querschnitt auch polygonal begrenzt sein. Die Magnete 31 sind im Winkel α schräg zur Längsachse der Kathodenanordnung 6 geschnitten und besitzen somit geneigte Endfläche 44. Der winkel α beträgt vorteilhafterweise 45° bis 75°. Die Magnete 31 sind derart magnetisiert, daß ihre Pole in den Endflächen 44 liegen, u.zw. so, daß die Magnetisierungsrichtung parallel zur Längsachse der Kathodenanordnung 6 verläuft. Ferner sind aufeinanderfolgende Magnete 31 derart angeordnet, daß jeweils entgegengesetzt Magnetpole einander zugekehrt sind.

Die Magnete 31 erzeugen ein magnetisches Streufeld, das einen schräg zur Längsachse verlaufenden, ringförmigen Plasmaeinschluß 39 vor der Lagerinnenfläche 19 bewirkt. Durch die Rotation der Magnete wird eine Rotation der Plasmazonen bewirkt, wobei durch diese Taumelbewegung eine gleichmäßige Abstäubung von der Targetoberfläche erreicht wird.

Die Magnete sind in einem dünnen Hüllrohr 35 angeordnet und von einem Targetträgerrohr 36 umgeben, auf das Ringe 37,37′ aus Targetmaterial aufgezogen sind. Zwischen den Ringen 37,37′ aus Targetmaterial und dem Trägerrohr 36 ist eine Wärmekontaktschicht 38 aus weichem, gut wärmeleitendem, niedrig schmelzendem, verformbarem Material, z.B. Indium, Gallium, Blei od.dgl., angeordnet. Dieses Material soll ferner einen Wärmeausdehnungskoeffizienten besitzen, der größer ist als der des Targetmaterials. Die Anzahl, das Material, die Breite und die Dicke der Ringe werden vom Anwendungsfall bestimmt.

Die Hohlwelle 30 mit den schräg geschnittenen Magneten 31 ist innerhalb des Trägerrohres 36 rotierbar angeordnet. Zwischen den Ringen 37,37′ und der Innenfläche 19 der Lager 3, die im Träger 4 in Reihen angeordnet sind, findet eine Gasentladung statt und die vom Targetmaterial abgetragenen Teilchen werden auf der Fläche 19 abgelagert.

Durch die Hohlwelle 30 wird Kühlmedium 41, vorzugsweise Wasser, von einer Kühlmittelzufuhreinrichtung 32 zugeführt und gelangt durch die Hohlwelle 30 zu einer schalen- bzw. halbtorusförmigen Umlenkung 47, mit der das Kühlmedium 41 aus der Hohlwelle 30 in einen zylindrischen Spalt 43 zwischen den Magneten 31 bzw. dem Hüllrohr 35 und dem Trägerrohr 36 geleitet wird. Aus dem Spalt 43 wird das Wasser aus der Kathodenanordnung 6 abgeführt.

Die Außenfläche der Magnete 31, die Außen- bzw. Innenfläche des Trägerrohres 36 und die Querschnittsform der Ringe können zylindrisch oder in Form eines Vielecks mit möglichst hoher Eckenanzahl ausgebildet sein.

Fig. 3 zeigt einen Ausschnitt aus der konzentrischen Anordnung der zu beschichtenden Lager und der Sputterkathodenanordnung. Zwischen dem Trägerrohr 36 und den Ringen 37,37′,37˝ aus unterschiedlichem Targetmaterial ist eine vorzugsweise 5 - 50 »m, insbesondere 10 - 20 »m, dicke Wärmekontaktschicht 38 aus weichem, niedrig schmelzendem, gut wärmeleitendem Metall, z.B. In, Ga, Pb od.dgl., vorgesehen. Diese Schicht besitzt eine Härte insbesondere <20 MHV und einen Schmelzpunkt, der kleiner als die Erweichungs- bzw. Schmelztemperatur des jeweiligen Targetmaterials ist. Die aufeinanderfolgenden Ringe 37,37′,37˝ aus gegebenenfalls unterschiedlichen Targetmaterialien sind gegebenenfalls in warmem Zustand auf das Trägerrohr 36 aufgezogen und sitzen nach dem Abkühlen mit Preßsitz auf dem Trägerrohr 36 bzw. der verformbaren Wärmekontaktschicht 38. Die Ringe können verschiedene Breite aufweisen, besitzen vorzugsweise jedoch gleiche Wandstärke. Gemäß Fig. 2 sind zwischen breiten Al-Ringen 37 schmale Pb-ringe 37′ dargestellt, womit sich Al-Pb-Legierungen aufsputtern lassen.

Es können auch mehrere Wärmekontaktschichten 38 übereinander vorgesehen werden bzw. anstelle von Reinmetallen für die Schicht 38 sind auch Legierungen, z.B. Wood'sches Metall, Sn-Pb-Legierungen usw. einsetzbar. Es ist auch möglich, nur einen Ring bzw. Zylinder auf ein Targetrohr 36 aufzuziehen.

Fig. 4 zeigt eine Ansicht eines abwechselnd Ringe 37 bzw. 37′ aus unterschiedlichen Materialien tragenden Trägerrohres 36, das auf das Permanentmagnetsystem aufsteckbar ist und in der Halterung 5 befestigt wird.

Mit 18 ist in Fig. 1 eine Einrichtung angedeutet, mit der der die Lagerschale 3 tragende Träger 4 auf Führungseinrichtungen 2, z.B. Schienen, in eine Relativbewegung zum Trägerrohr 36, insbesondere eine Vorschubbewegung und/oder Hin- und Herbewegung bzw. Pendelbewegung in Längsrichtung der Kathodenanordnung 6 und/oder in eine Rotation um diese versetzbar ist. Durch derartige Bewegungen kann das Aufsputtern von Legierungsschichten mit nebeneinanderliegenden Ringen 37,37′,37˝ aus unterschiedlichen Materialien vergleichmäßigt werden. Mit 18′ ist eine außerhalb des Rezipienten 1 angeordnete Antriebseinrichtung, z.B. ein Motor, und mit 18˝ sind vakuumdicht geführte Kraftübertragungseinrichtungen,z.B. Stangen, Wellen od.dgl., für die Einrichtung 18, z.B. einem auf Rollen auf den Schienen 2 verfahrbaren Schlitten, angedeutet.

Bevorzugterweise wird die erfindungsgemäße Kathodenanordnung zur Innenbeschichtung von Hohlkörpern, z.B. auch aus ferromagnetischen Stoffen, eingesetzt, da letztere z.B. mit Sputterverfahren mit einem außerhalb der Kathode erzeugten Magnetfeld aufgrund ihres abschirmenden Effektes nicht beschichtet werden können.

Das Trägerrohr 36 kann z.B. 1 - 10 mm Wandstärke aufweisen. Das die Magnete 31 einschließende Hüllrohr 35 kann 0,5 - 2 mm stark sein. Die Breite des Kühlspaltes 43 beträgt zwischen 0,3 bis 10 mm. Die Magnete 31 besitzen einen Durchmesser von etwa 5 - 50 mm. Die Rotation der Magnete erfolgt mit etwa 60 - 1200 UpM. Der gesamte Hub einer Pendelbewegung kann etwa 50 mm betragen, die Pendelfrequenz z.B. 1 Hz, die Vorschubgeschwindigkeit etwa 1 cm/min.

Zu bemerken ist noch, daß die Magnete 31 nicht notwendigerweise von einer Hohlwelle 30 getragen und von einem Hüllrohr 35 umgeben sein müssen. Es sind auch Ringmagnete denkbar, die zusammengeklebt sind und durch deren hohlen Kern anstatt durch die Hohlwelle 30 das Kühlmittel zugeleitet wird. Prinzipiell ist es auch möglich, das Kühlmittel durch den Spalt 43 zuzuleiten; eine bessere Wärmeabfuhr wird jedoch im erfindungsgemäßen beschriebenen Fall erreicht.

Es ist auch möglich, die Zwischenschicht 38 auf die Innenfläche der Ringe 37,37′,37˝ aufzubringen, das Trägerrohr 36 durch Abkühlen, z.B. in flüssiger Luft, zu schrumpfen und auf das geschrumpfte Trägerrohr 36 die gegebenenfalls bis unterhalb des Schmelzpunktes der Zwischenschicht 38 erwärmten Ringe 37,37′,37˝ aufzuziehen. Der Träger 4 kann von einer die Lager 3 umschließenden gegebenenfalls einstückigen Röhre gebildet sein.

Als Targetmaterial kommen auch elektrisch nicht leitende Materialien, z.B. Kunststoff, Keramik, Glas usw. in Betracht. Unter dem Begriff "Sputtern" wird auch das sogenannte "reaktive" Sputtern und auch das sogenannte RF-Sputtern verstanden, das mit einem RF (radio frequency)-Feld im Entladungsraum erfolgt.

## Patentansprüche

1. Stabförmige Magnetron- bzw. Sputterkathodenanordnung mit einem innenliegenden, gekühlten Permanentmagnetsystem und einem Trägerrohr (36) für das auf das stabförmige, vorzugsweise aus nichtmagnetischem Stahl, bestehende Trägerrohr (36) aufgebrachte, gegebenenfalls aus unterschiedlichen Targetmaterialien zusammengesetzte Target, dadurch gekennezichnet, daß zwischen dem aus einem oder mehreren, insbesondere austauschbar auf das Trägerrohr (36) aufgezogenen Ring(en) (37, 37′, 37˝) bestehenden Target und dem Trägerrohr (36) zumindest eine Wärmekontaktschicht (38) angeordnet ist und daß der bzw. die gegebenenfalls im warmen Zustand auf das Trägerrohr (36) aufgebrachte(n) Ring(e) (37, 37′, 37˝) im Betriebszustand mit Preßsitz auf dem Trägerrohr (36) bzw. der Wärmekontaktschicht (38) sitzt bzw. sitzen.

2. Anordnung nach Anspruch 1, dadurch gekennzeichnet, daß die zwischen dem(n) Ring(en) (37, 37′, 37˝) und dem Trägerrohr (36) angeordnete, vorzugsweise 5 - 50 »m, insbesondere 10 - 20 »m, dicke Wärmekontaktschicht (38) aus weichem bzw. verformbarem, insbesondere mit einer Härte < 20 MHV, niedrig schmelzendem, gut wärmeleitendem Metall bzw. einer solchen Legierung, z.B. In, Ga, Pb, Sn, Wood'sches Metall, od.dgl., besteht, die vorzugsweise auf das Trägerrohr (36) abgelagert ist.

3. Anordnung nach Anspruch 1 oder 2, dadurch gekennzeichnet, daß der Schmelzpunkt des Metalles bzw. der Legierung der Wärmekontaktschicht (38) bei Temperaturen unterhalb des Erweichungspunktes oder Schmelzpunktes des aufgebrachten Targetmaterials liegt.

4. Anordnung nach einem der Ansprüche 1 bis 3, dadurch gekennzeichnet, daß das Metall der Wärmekontaktschicht (38) einen Wärmeausdehnungskoeffizienten besitzt, der größer ist als der des Targetmaterials.

5. Anordnung nach einem der Ansprüche 1 bis 4, dadurch gekennzeichnet, daß auf das Trägerrohr (36) in axialer Richtung aufeinanderfolgend insbesondere in vorbestimmter Reihenfolge Ringe (37, 37′, 37˝) gegebenenfalls unterschiedlicher Breite aus unterschiedlichem Targetmaterial aufgezogen sind.

6. Anordnung nach einem der Ansprüche 1 bis 5, bei der im Inneren des Trägerrohres um dessen Längsachse insbesondere kontinuierlich rotierbare, z.B. von einer rotierbaren Welle getragene, und vom Kühlmedium umströmte Permanentmagnete angeordnet sind, dadurch gekennzeichnet, daß die Magnete (31) mit in Längsrichtung des Trägerrohres (36) alternierend entgegengesetzter Richtung ihres Magnetfeldes innerhalb des Trägerrohres (36) angeordnet sind.

7. Anordnung nach Anspruch 6, dadurch gekennzeichnet, daß die zylindrische oder polygonale Mantelflächenbesitzenden Magnete (31) parallele und im Winkel (α) zur Längsrichtung der Elektrode (6) bzw. Welle (30) geneigt verlaufende Endflächen (44) besitzen, wobei die einander zugewandten Endflächen (44) aufeinanderfolgender Magnete (31) entgegengesetzte Magnetpole aufweisen.

8. Anordnung nach einem der Ansprüche 1 bis 7, dadurch gekennzeichnet, daß die Magnete (31) eine rohrförmige Ausnehmung in Längsrichtung des Trägerrohres (36) aufweisen, mit der sie gegebenenfalls auf die Welle (30) aufgeschoben sind, daß die Ausnehmung bzw. die als Hohlwelle ausgebildete Welle (30) als Kühlmitteldurchfluß ausgebildet und an eine Kühlmittelzufuhreinrichtung (32) angeschlossen ist und daß die Magnete (31) in dem Trägerrohr (36) unter Ausbildung eines Spaltes (43) angeordnet sind, wobei der Spalt (43) zwischen dem Trägerrohr (36) und den gegebenenfalls von einem Hüllrohr (35) umgebenen Magneten (31) als Kühlmitteldurchfluß, insbesondere Kühlmittelrückleitung, ausgebildet ist.

9. Sputterverfahren zum Sputtern mit einer Magnetron- bzw. Sputterkathodenanordnung insbesondere nach einem der Ansprüche 1 bis 8, vorzugsweise zum Besputtern von gekrümmte Bereiche aufweisenden Flächen, z.B. den Innenflächen von Hohlkörpern, wobei die zu besputternde Fläche und die Kathodenanrodnung, die ein Trägerrohr umfaßt, auf das unterschiedliche Targetmaterialien aufgebracht sind, einer gegenseitigen Relativbewegung unterworfen werden, wobei vorzugsweise die Kathodenanordnung lagefest gehalten und die Fläche bzw. der die Fläche tragende Körper bewegt wird, dadurch gekennzeichnet, daß die Kathodenanordnung, auf deren Trägerrohr mehrere in axialer Richtung des Trägerrohres aufeinanderfolgende Ringe aus unterschiedlichem Targetmaterial aufgezogen werden, und die zu besputternde Fläche einer gegenseitigen Relativbewegung in Längsrichtung der Kathodenanordnung bzw. des Trägerrohres unterworfen werden

10. Verfahren nach Anspruch 9, dadurch gekennzeichnet, daß die Relativbewegung zwischen der Kathodenanordnung und der zu besputternden Fläche eine Pendelbewegung ist, deren Hub größer als die Breite eines, insbesondere des breitesten vorhandenen, Ringes aus Targetmaterial, gewählt ist.

11. Verfahren nach Anspruch 9, dadurch gekennzeichnet, daß die Relativbewegung eine Verschiebebewegung ist und eine Vorschubbewegung des die zu besputternde Fläche tragenden Körpers in bezug auf die Längsrichtung der Kathodenanordnung (6) umfaßt, der eine Pendelbewegung überlagert ist.

12. Vorrichtung zur Durchführung des Verfahrens nach einem der Ansprüche 9 bis 11 mit einer Verstelleinrichtung, dadurch gekennzeichnet, daß die Kathodenanordnung (6) und/oder die zu besputternde Fläche (19) von der von einer in Längsrichtung des Trägerrohres (36) eine Vorschub- und/oder Hin- und Herbewegung (Pendelbewegung) ausführenden Trägereinrichtung gebildeten Verstelleinrichtung (18), die gegebenenfalls von einer Förder- bzw. Antriebseinrichtung (18′) betätigbar ist, getragen bzw. mit dieser verbunden sind.

13. Rohrförmiges Target insbesondere für stabförmige Magnetron- bzw. Sputterkathodenanordnungen mit einem Trägerrohr für das Targetmaterial insbesondere nach einem der Ansprüche 1 bis 8 oder zur Durchführung des Verfahrens nach einem der Ansprüche 9 bis 12, dadurch gekennzeichnet, daß zwischen dem Trägerrohr (36) des rohrförmigen Targets und dem Targetmaterial zumindest eine vorzugsweise 5 - 50 »m, insbesondere 10 - 20 »m, dicke Wärmekontaktschicht (38) aus weichem bzw. verformbaren, insbesondere mit einer Härte < 20 MHV, niedrig schmelzendem, gut wärmeleitendem Metall oder einer entsprechenden Legierung, z.B. In, Ga, Pb, Sn, Wood'sches Metall, od.dgl. vorgesehen ist, wobei auf das Trägerrohr (36) in axialer Richtung zumindest ein, vorzugsweise eine Anzahl aufeinanderfolgender gegebenenfalls aus unterschiedlichen Targetmaterialien bestehender, gegebenenfalls unterschiedliche Breite besitzender, Ring(e) (37, 37′, 37˝) aufgebracht ist, wobei der (die) Ring(e) gegebenenfalls in warmem Zustand auf das Trägerrohr (36) aufgezogen und nach dem Abkühlen im Betriebszustand mit Preßsitz auf dem Trägerrohr (36) bzw. der Wärmekontaktschicht (38) angeordnet ist (sind), wobei gegebenenfalls das Metall der Schicht(en) (38) einen Wärmeausdehnungskoeffizienten besitzt, der größer ist als der des Targetmaterials.

## Claims

1. A magnetron or sputter cathode arrangement in rod form comprising an internal cooled permanent magnet system and a carrier tube (36) for the target which is applied to the rod-shaped, preferably non-magnetic steel carrier tube (36), and which if required consists of different target materials, characterised in that at least one thermal contact layer (38) is disposed between the target tube (36) and the target consisting of one or more rings (37, 37′, 37˝) shrunk on to the carrier tube (36), more particularly so as to be interchangeable, and in that the or each ring (37, 37′, 37˝) applied, if required, in the hot state to the carrier tube (36) fits, in the operative state, on the carrier tube (36) or thermal contact layer (38) with a press fit.

2. An arrangement according to claim 1, characterised in that the thermal contact layer (38) which is disposed between the ring or rings (37, 37′, 37˝) and the carrier tube (36) and which is preferably 5 to 50 »m, more particularly 10 to 20 »m, thick, consists of low-melting metal of good thermal conductivity and is soft or deformable, more particularly with a hardness of less than 20 MHV, or an alloy of this kind, e.g. In, Ga, Pb, Sn, Wood's metal, or the like, which is preferably deposited on the carrier tube (36).

3. An arrangement according to claim 1 or 2, characterised in that the melting point of the metal or alloy of the thermal contact layer (38) is at temperatures below the softening point or melting point of the applied target material.

4. An arrangement according to any one of claims 1 to 3, characterised in that the metal of the thermal contact layer (38) has a coefficient of thermal expansion greater than that of the target material.

5. An arrangement according to any one of claims 1 to 4, characterised in that rings (37, 37′, 37˝), if required of different widths and of different target material, are shrunk on the carrier tube (36) in a consecutive arrangement axially, more particularly in a predetermined sequence.

6. An arrangement according to any one of claims 1 to 5, wherein permanent magnets are disposed inside the carrier tube for rotation, more particularly continuous rotation, about the longitudinal axis of the carrier tube, such magnets being carried, for example, by a rotatable shaft and having a cooling medium flowing around them, characterised in that the magnets (31) are disposed inside the carrier tube (36) with the directions of their magnetic field alternately opposed in the longitudinal direction of the carrier tube (36).

7. An arrangement according to claim 6, characterised in that the magnets (31) having cylindrical or polygonal outer surfaces have parallel end faces (44) extending at an angle (α) to the longitudinal direction of the electrode (6) or shaft (30), the facing end faces (44) of consecutive magnets (31) having opposed poles.

8. An arrangement according to any one of claims 1 to 7, characterised in that the magnets (31) have a tubular recess in the longitudinal direction of the carrier tube (36), whereby they are slipped on to the shaft (30), if required, in that the recess or the shaft (30) constructed as a hollow shaft is constructed as a coolant passage and is connected to a coolant supply means (32) and in that the magnets (31) are disposed in the carrier tube (36) so as to form a gap (43), the gap (43) between the carrier tube (36) and the magnets (31), surrounded by an enclosing tube (35) is required, is constructed as a coolant passage, more particularly a coolant return passage.

9. A sputter process for sputtering by means of a magnetron or sputter cathode arrangement, more particularly according to any one of claims 1 to 8, preferably for sputtering surfaces having curved zones, e.g. the inside surfaces of hollow articles, the surface for sputtering and the cathode arrangement, which comprises a carrier tube, to which different target materials are applied, being subjected to a mutual relative movement, the cathode arrangement preferably being kept in a fixed position and the surface or the article which has the surface being moved, characterised in that the cathode arrangement on whose carrier tube a plurality of rings of different target materials are shrunk on successively in the axial direction of the carrier tube, and the surface for sputtering, are subjected to mutual relative movement in the longitudinal direction of the cathode arrangement and of the carrier tube.

10. A method according to claim 9, characterised in that the relative movement between the cathode arrangement and the surface for sputtering is a rocking movement, the amplitude of which is greater than the width of a target material ring, more particularly the widest ring.

11. A method according to claim 9, characterised in that the relative movement is a sliding movement and comprises a feed movement of the article with the surface for sputtering with respect to the longitudinal direction of the cathode arrangement (6), on which a rocking movement is superimposed.

12. Apparatus for performing the method according to any one of claims 9 to 11, with an adjustment means, characterised in that the cathode arrangement (6) and/or the surface (19) for sputtering is carried by or connected to the adjustment means (18), such means being formed by a carrier device performing a feed and/or reciprocating movement (rocking movement) in the longitudinal direction of the carrier tube (36), such adjustment means (18) being operable, if required, by a conveyor or drive means (18′).

13. A tubular target, more particularly for magnetron or sputter cathode arrangements in the form of a rod comprising a carrier tube for the target material, more particularly according to any one of claims 1 to 8, or for performing the method according to any one of claims 9 to 12, characterised in that at least one thermal contact layer (38) preferably 5 to 50 »m, more particularly 10 to 20 »m, thick is disposed between the carrier tube (36) of the tubular target and the target material, such layer consisting of low-melting metal of good thermal conductivity and being soft or deformable, more particularly with a hardness of less than 20 MHV, or a corresponding alloy, e.g. In, Ga, Pb, Sn, Wood's metal or the like, at least one, and preferably a plurality of, consecutive rings (37, 37′, 37˝) being applied to the carrier tube (36) axially, such rings, if required, consisting of different target materials and, if required, having different widths, the or each ring, if required, being shrunk hot on to the carrier tube (36) and after cooling having, in the operating state, a press fit on the carrier tube (36) or the thermal contact layer (38), the metal of the layer or layers (38), if required, having a coefficient of thermal expansion greater than that of the target material.

## Revendications

1. Dispositif à magnétron ou à cathode de pulvérisation, se présentant sous forme de barre avec un système à magnétisme permanent interne refroidi, et un tube support (36) pour la cible, monté sur le tube support (36) en forme de barre, réalisé de préférence en acier non magnétique, composée le cas échéant de matériaux de cibles différents, caractérisé en ce qu'entre la cible, composée d'un ou plusieurs anneaux (37, 37′, 37˝), enfilés en particulier de façon remplaçable sur le tube-support (36), et le tube- support (36) est disposé au moins une couche de contact thermique (38), et en ce que le ou les anneaux (37, 37′, 37˝) appliqués le cas échéant sur le tube-support (36) à l'état chaud est, respectivement, sont monté(s) avec ajustement serré, à l'état de fonctionnement sur le tube- support (36), respectivement la couche de contact thermique (38).

2. Dispositif selon la revendication 1, caractérisé en ce que la couche de contact thermique (38) disposée entre le ou les anneaux (37, 37′, 37˝) et le tube-support (36), ayant une épaisseur de préférence de 5 à 50 »m en particulier de 10 à 20 »m, est réalisé en un matériau mou, respectivement déformable, en particulier ayant une dureté inférieure à 20 MHV, fondant à faible température, bon conducteur de la chaleur, respectivement en un alliage, par exemple de In, Ga, PB, Sn, un métal de Wood ou analogue, déposé de préférence sur le tube support (36).

3. Dispositif selon la revendication 1 ou 2, caractérisé en ce que le point de fusion du métal, respectivement de l'alliage de la couche de contact thermique (38) est situé à des températures inférieures au point de ramollissement ou au point de fusion du matériau de cible appliqué.

4. Dispositif selon l'une des revendications 1 à 3,
caractérisé en ce que le métal de la couche de contact thermique (38) a un coefficient de dilatation thermique supérieur à celui du matériau de cible.

5. Dispositif selon l'une des revendications 1 à 4,
caractérisé en ce que des anneaux (37, 37′, 37˝), ayant, le cas échéant, des largeurs différentes et est réalisés en des matériaux de cibles différents sont enfilés sur le tube support (36), en se suivant en direction axiale, en particulier selon un ordre de succession prédéterminé.

6. Dispositif selon l'une des revendications 1 à 5,
dans lequel, à l'intérieur du tube support,des aimants permanents sont disposés autour de son axe longitudinal, en particulier en pouvant tourner de façon continue, en étant, par exemple, portés par un arbre tournant et en étant contournés par un écoulement d'agent de refroidissement, caractérisé en ce que les aimants (31) sont disposés avec une direction de leur champ magnétique à l'intérieur du tube-support (36) allant en alternant dans la direction longitudinale du tube-support (36).

7. Dispositif selon la revendication 6,
caractérisé en ce que les aimants (31) ayant des surfaces d'enveloppe cylindriques ou polygonales ont des surfaces d'extrémité (44) parallèles et inclinées d'un angle (α) par rapport à la direction longitudinale de l'électrode (6), respectivement de l'arbre (30), les faces d'extrémité (44), tournées les unes vers les autres, d'aimants (31) se suivant les uns les autres ayant des pôles magnétiques opposés.

8. Dispositif selon l'une des revendications 1 à 7,
caractérisé en ce que les aimants (31) présentent un évidement tubulaire dans la direction longitudinale du tube support (36), à l'aide duquel le cas échéant ils sont enfilés sur l'arbre (30) en ce que l'évidement respectivement l'arbre (30) réalisés sous forme d'arbres creux sont réalisés avec passage d'un écoulement d'agent de refroidissement et raccordés à un dispositif d'amenée d'agent de refroidissement (32) et en ce que les aimants (31) sont disposés dans le tube-support (36) en constituant un entrefer (43), l'entrefer (43) étant constitué entre le tube-support (36) et les aimants (31) entourés, le cas échéant, par un tube enveloppe (35), constituant un passage d'écoulement de l'agent de refroidissement, en particulier une conduite de retour de l'agent de refroidissement.

9. Procédé de pulvérisation, pour pulvériser avec un dispositif à magnétron ou à pulvérisation cathodique, en particulier selon l'une des revendications 1 à 8, de préférence pour garnir par pulvérisation des surfaces présentant des zones courbes, par exemple les surfaces intérieures de corps creux, la surface à pulvériser et le dispositif à cathode, comprenant un tube-support, sur lequel sont appliqués différents matériaux de cible, étant soumis à un déplacement relatif mutuel où, de préférence, le dispositif à cathode est maintenu en position fixe et la surface ou le corps portant la surface étant déplacé(e)s,
caractérisé en ce que le dispositif à cathode, sur le tube-support duquel plusieurs anneaux successifs en matériaux de cible différents sont enfilés dans la direction axiale du tube-support et la surface à garnir par pulvérisation étant soumis à un mouvement relatif mutuel dans la direction longitudinale dans le dispositif à cathode, respectivement du tube-support.

10. Procédé selon la revendication 9,
caractérisé en ce que le déplacement relatif entre le dispositif à cathode et la surface à pulvériser est un mouvement pendulaire, dont la course est supérieure à la largeur d'un anneau en matériau de cible, de préférence de l'anneau présentant la largeur maximale.

11. Procédé selon la revendication 9,
caractérisé en ce que le mouvement relatif est un mouvement coulissant et comprend un mouvement d'avance du corps comprenant la surface à pulvériser par rapport à la surface longitudinale du dispositif à cathode (6), auquel est superposé un mouvement pendulaire.

12. Dispositif pour mettre une oeuvre le procédé selon l'une des revendications 9 à 11, avec un dispositif de réglage,
caractérisé en ce que le dispositif à cathode (6) et/ou la surface (19) à pulvériser sont portés par le dispositif de réglage (18), constitué par un dispositif-support effectuant un mouvement d'avance et/ou un mouvement de va-et-vient (mouvement pendulaire) dans la direction longitudinale du tube-support (36), le dispositif de réglage (18) étant, le cas échéant, actionnable par, porté par, respectivement relié à, un dispositif de transport, respectivement d'entraînement (18′).

13. Cible tubulaire, en particulier pour des dispositifs à magnétron, respectivement à cathode de pulvérisation avec un tube-support pour le matériau de cible, en particulier selon l'une des revendications 1 à 8, ou pour mettre en oeuvre le procédé selon l'une des revendications 1 à 12,
caractérisé en ce que, entre le tube-support (36) de la cible tubulaire et le matériau de cible, est prévue au moins une couche d'isolation thermique (38) présentant, de préférence, une épaisseur de 5 à 50 »m, en particulier de 10 à 20 »m, en métal souple, respectivement déformable, en particulier d'une dureté inférieure à 20 MHV, fondant à basse température, bon conducteur de la chaleur, ou en un alliage correspondant, par exemple à base de In, Ga, Pb, Sn, un métal de Wood ou analogue, un nombre déterminé d'anneaux (37, 37′, 37˝) se suivant, le cas échéant, réalisés en matériaux de cibles différents ayant le cas échéant des largeurs différentes, étant montés sur le tube support (36), en direction axiale, le ou les anneaux étant enfilés, le cas échéant, à l'état chaud sur le tube support (36) et disposés, après refroidissement, à l'état de fonctionnement, avec un ajustement serré, sur le tube support (36), respectivement sur la couche de contact thermique (38), le cas échéant, le métal de la ou des couche(s) (38) ayant un coefficient de dilatation thermique supérieur à celui du matériau de cible.
